# EUROPEAN PATENT APPLICATION

(11) **EP 3 477 388 A1**
(43) Date of publication of application: **01.05.2019**
(21) Application number: 17870622.2
(22) Date of filing: 25.08.2017
(51) Int. Cl.: G03F 7/00

(54) **LIGHT SENSING ELEMENT CAPABLE OF FORMING ELECTRIC POTENTIAL ENERGY GRADIENT**

(71) Applicant: Shenzhen Goodix Technology Co., Ltd., Shenzhen, Guangdong 518045 (CN)
(72) Inventor: LIU, Yichen, Taipei City Taiwan 100 (TW); YANG, Mengta, Taipei City Taiwan 100 (TW)
(74) Representative: Becker Kurig Straus
(86) International application number: PCT/CN2017/099118
(87) International publication number: WO 2019/037104

(57) **Abstract**

A light sensing element configured to receive a light is disclosed. The light sensing element comprises an active region; and the plurality of gates, arranged in an order and disposed on the active region, wherein the plurality of gates receives a plurality of gate voltages, the plurality of gate voltages are corresponding to the plurality of gates arranged in the order, respectively; wherein the plurality of gate voltages are increasing or decreasing as the order.

## Description

### Field of the Invention

The present invention/application relates to a light sensing element, and more particularly, to a light sensing element capable of forming a potential gradient.

### Background

Optical distance measuring device may utilize 3D image sensing system to collect the distance/depth information related to a target. Through the distances/depths corresponding to the pixels of the 3D images, 3D image data is formed. 3D images are also called as distance images or depth images. The extra distance dimension may be applied in various applications, so as to obtain information between the camera and the object, to accomplish different tasks in the sensing area in the field.

In general, optical distance measuring device comprises far infrared ray (FIR) photo diode. Since the FIR has larger wavelength, the FIR would form the photo electrons at a deeper depth with in an active region of the photo diode. The photo electrons at such depth are not easy to be drained out to form the photo current, which is called as the lagged phenomenon. The lagged phenomenon causes the photo diode to be insensitive to the light, meaning that the photo current caused by the light is smaller. The lagged phenomenon would affect a measurement results generated by the optical distance measuring device, and degrade the overall performance.

Therefore, it is necessary to improve the prior art.

### Summary

It is therefore a primary objective of the present application to provide a light sensing element capable of forming a potential gradient, to improve over disadvantages of the prior art.

To solve the problem stated in the above, an embodiment of the present application provides a light sensing element, configured to receive a light. The light sensing element comprises an active region; and a plurality of gates, arranged in an order and disposed on the active region, wherein the plurality of gates receives a plurality of gate voltages, the plurality of gate voltages are corresponding to the plurality of gates arranged in the order, respectively; wherein the plurality of gate voltages are increasing or decreasing as the order.

For example, the plurality of gates are arranged from a center of the active region to a periphery of the active region, and the plurality of gate voltages applied to the plurality of gates are increasing from the center to the periphery.

For example, the light sensing element comprises a plurality of first gates, arranged from a center of the active region to a first end of the active region, wherein the plurality of first gate voltages applied to the plurality of first gates are increasing from the center to the first end; and a plurality of second gates, arranged from the center of the active region to a second end of the active region, wherein the plurality of second gate voltages applied to the plurality of second gates are increasing from the center to the second end; wherein the first end is opposite to the second end.

For example, the light sensing element comprises a plurality of first gates, arranged from a center of the active region to a first end of the active region, wherein the plurality of first gate voltages applied to the plurality of first gates arc decreasing from the center to the first end; and a plurality of second gates, arranged from the center of the active region to a second end of the active region, wherein the plurality of second gate voltages applied to the plurality of second gates are decreasing from the center to the second end; wherein the first end is opposite to the second end.

For example, the plurality of gates are arranged from a first end of the active region to a second end of the active region, the first end is opposite to the second end, and the plurality of gate voltages are increasing from the first end to the second end.

For example, the plurality of gates are arranged from a first end of the active region to a second end of the active region, the first end is opposite to the second end, the plurality of gate voltages are increasing from the first end to the second end during a first time period, and the plurality of gate voltages are decreasing from the first end to the second end during a second time period.

For example, the plurality of gates are mutually parallel.

For example, the gates are poly-silicon gates.

For example, a wavelength to the light is greater than 700nm.

For example, the light sensing element is a photo diode.

For example, the light sensing element is applied in a ToF based distance measuring device.

The present application utilizes the plurality of gates disposed on the active region and the increasing (or decreasing) gate voltages, to form the potential gradient within the active region and enhance the drifting capability of the photo electrons. The light sensing element of the present application has better draining/reading capability of the photo electron/current. These and other objectives of the present invention will no doubt become obvious to those of ordinary skill in the art after reading the following detailed description of the preferred embodiment that is illustrated in the various figures and drawings.

### Brief Description of the Drawings

FIG. 1 is a schematic diagram of a top view of a light sensing element according to an embodiment of the present application.
FIG. 2 is a schematic diagram of potential profile of the light sensing element of FIG. 1.
FIG. 3 is a schematic diagram of a top view of a light sensing element in the prior art.
FIG. 4 is a schematic diagram of potential profile of the light. sensing element of FIG. 3.
FIG. 5 is a schematic diagram of potential profile of the light sensing element of FIG. 1.
FIG. 6 is a schematic diagram of potential profile of the light sensing element of FIG. 1.
FIG. 7 is a schematic diagram of a top view of a light sensing element according to an embodiment of the present application.
FIG. 8 is a schematic diagram of potential profile of the light sensing element of FIG. 7.
FIG. 9 is a schematic diagram of potential profile of the light sensing element of FIG. 7.

### Detailed Description

In order to make the objects, technical solutions and advantages of the present invention become more apparent, the following relies on the accompanying drawings and embodiments to describe the present invention in further detail. It should be understood that the specific embodiments described herein are only for explaining the present invention and are not intended to limit the present invention.

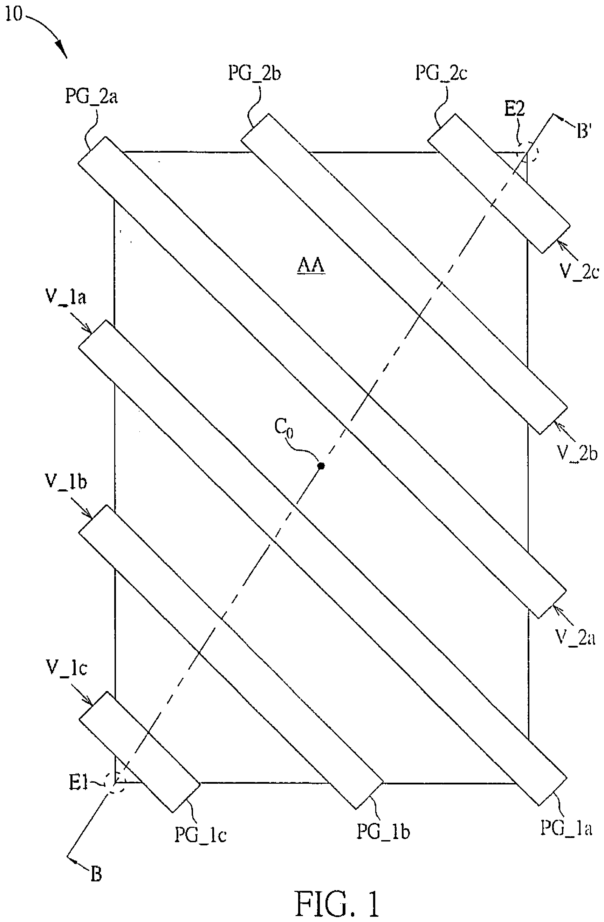

Please refer to FIG. 1. FIG. 1 is a schematic diagram of a top view of a light sensing element 10 according to an embodiment of the present application. The light sensing element 10 is a photo diode, configured to receive a light and generate photo electron (or photo current) correspondingly. The light sensing element 10 comprises an active region/area AA and gates PG_1a, PG_1b, PG_1c, PG_2a, PG_2b and PG_2c. The gates PG_1a, PG_1b, PG_1c, PG_2a, PG_2b and PG_2c, which may be poly-silicon gates, are disposed on Lhe active region AA and parallel to each other. The gates PG_1a, PG_1b, PG_1c, PG_2a, PG_2b and PG_2c may receive gate voltages V_1a, V_1b, V_1c, V_2a, V_2b and V_2c. The gates PG_1a, PG_1b and PG_1c are arranged from a center C₀ of the active region AA to a first end E1 of the active region AA; while the gates PG_2a, PG_2b and PG_2c are arranged from the center C₀ of the active region AA to a second end E2 of the active region AA.

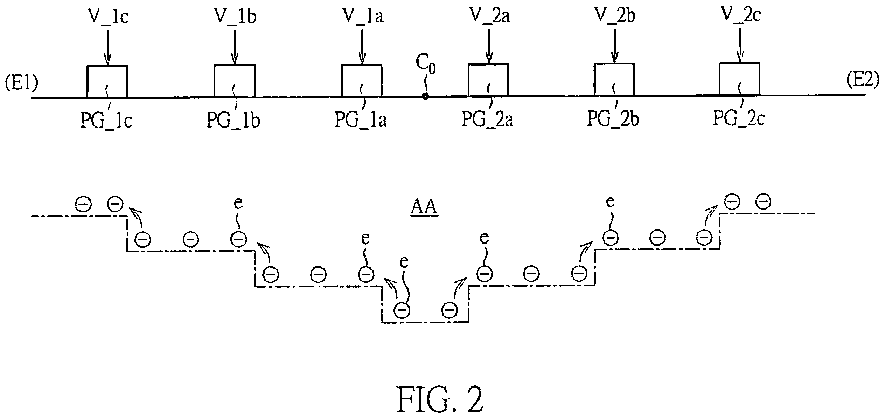

Please refer to FIG. 2. FIG. 2 is a schematic diagram of a sectional view of the light sensing element 10 along a B-B' Line. FIG. 2 also illustrates the potential profile formed by the gate voltages within the active region AA (along the B-B' section). In an embodiment, when the light sensing element 10 is activated, the gate voltages V_1a, V_1b and V_1c applied to the gates PG_1a, PG_1b and PG_1c are increasing from inside to outside of the active region AA (that is, increasing from the center C₀ to the first end E1, i.e., V_1a ≤ V_1b ≤ V_1c), and the gate voltages V_2a, V_2b and V_2c applied to the gates PG_2a, PG_2b and PG_2c are also increasing from inside to outside of the active region AA (that is, form the center C₀ to the second end E2, i.e., V_2a ≤ V_2b ≤ V_2c). In an embodiment, the voltages V_1a and V_2a may be V_1a = V_2a = 2V, the voltages V_1b and V_2 b may be V_1b = V_2b =3V, and the voltages V_1c and V_2c may be V_1c = V_2c = 4V, which is not limited thereto. In such a condition, the gate voltages V_1a, V_1b, V_1c, V_2a, V_2b and V_2c may form a stairs-like energy level or potential gradient. Therefore, an electron e at the center of the active region AA may be drifted toward a surface of the active region AA by the help of the voltages V_1a and V_2a, and drifted further upward (toward the surface) by the help of the voltages V_1b and V_2 b, and finally drifted to the surface and diffused, by the help of the voltages V_1c and V_2c, to form the photo current.

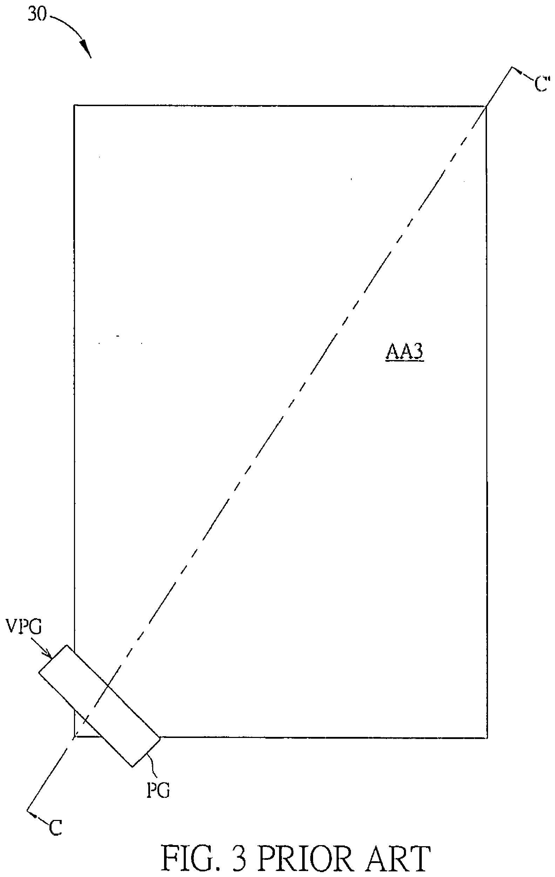

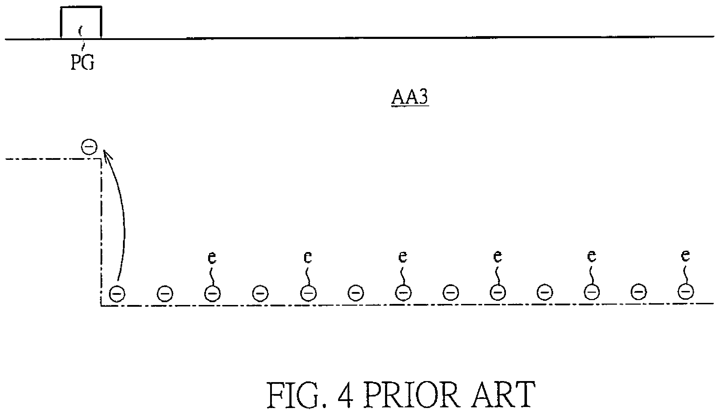

Please refer to FIG. 3 and FIG. 4. FIG. 3 is a schematic diagram of a top view of a light sensing clement 30 in the art. FIG. 4 is a schematic diagram of a sectional view of the light sensing element. 30 along a C-C' line and the potential gradient of the light sensing element 30 within an active region AA3 (along the C-C' section). The light sensing element 30 only comprises a single gate PG on the active region AA3, and the gate PG receives a single gate voltage VPG. The gate PG/gate voltage VPG only forms one level energy/potential variation within the active region AA3. The electron around the gate PG is easily drifted to the surface of the active region AA3; however, for the electrons far from the gate PG, it is not easy to be drifted to the surface of the active region AA3, causing that the electrons of the light sensing element 30 may have the lagged phenomenon. In other words, compared to the light sensing element 10, the photo current drained by the light sensing element 30 would be smaller, which is less sensitive to the light (i.e., the photo current generated by the light is smaller).

In another perspective, the light sensing element of the present application is especially suitable for sensing the light with larger wavelength (e.g., larger than 700 nm) to generate the photo current. For example, the suitable light may be near infrared ray (NIR), middle IR (MIR) or far-IR, etc. The depth at which the electron is formed within the active region (the vertical distance from the surface of the active region) is related to the wavelength of the light. The larger the wavelength of the light, the deeper the depth at which the electron is formed. For example, a light with wavelength about 300-450nm would form photo electrons at a depth about 1µm within the active region; a light with wavelength about 450-600nm would form photo electrons at a depth about 2µm within the active region; a light with wavelength about 600-750nm would form photo electrons at a depth about 3.5µm within the active region. For the light (IR) which wavelength is greater than 750nm, a depth at which the photo electron is formed may achieve 10µm.

In this case, if the light sensing element in the art (e.g., the light sensing element 30) is utilized to receive IR with larger wavelength and generate photo current corresponding to the IR, the lagged phenomenon of IR would be more serious, compared to which of the visible light, where the wavelength of the visible light is less than 700 nm. When the light sensing element in the art is applied in devices to sense the IR (e.g., the time-of-flight (ToF) based distance measuring device), the lagged phenomenon of the light sensing element in the art would affect the measurement results generated by the ToF based distance measuring device, and degrades the overall performance. In comparison, the light sensing element of the present application forms the stairs-like energy level or the potential gradient, and the photo electrons is able to be drifted to the surface of the active region gradually, which alleviates the problem of the lagged phenomenon in the art. That is, the light sensing element of the present application is more sensitive to the light (i.e., the photo current caused by the light is larger than the one generated by the light sensing element in the art). When the light sensing element of the present application is applied to the ToF based distance measuring device, the measurement result thereof would be more accurate.

Notably, the embodiments stated in the above are utilized for illustrating the concept of the present application. Those skilled in the art may make modifications and alterations accordingly, and not limited herein. For example, the gate voltages V_1a, V_1b and V_1c and the gate voltages V_2a, V_2b and V_2c in FIG. 1 are not limited to be increasing outward from the center. In an embodiment, when the photo current as drained at the gates PG_1a and PG_2a, the gate voltages V_1a, V_1b and V_1c and the gate voltages V_2a, V_2b and V_2c may be decreasing outward from the center (i.e., V_1a ≥ V_1b ≥ V_1c and V_2a ≥ V_2b ≥ V_2c), which is also within the scope of the present application.

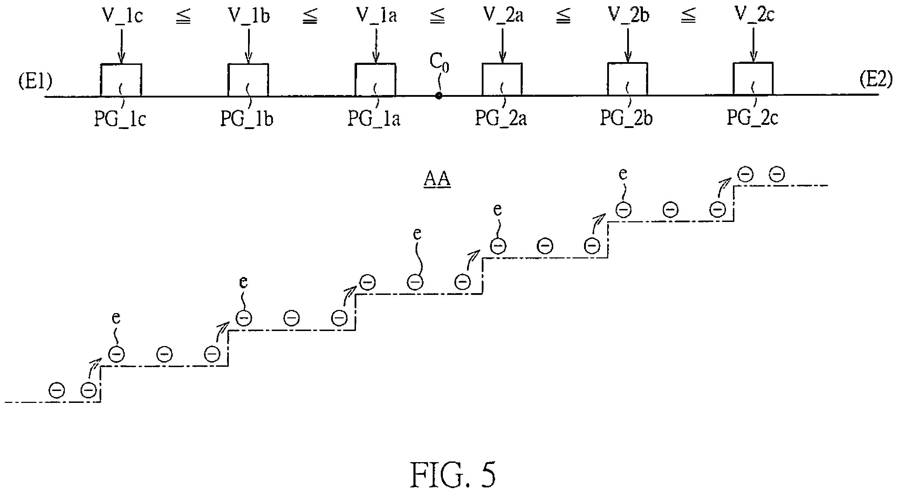

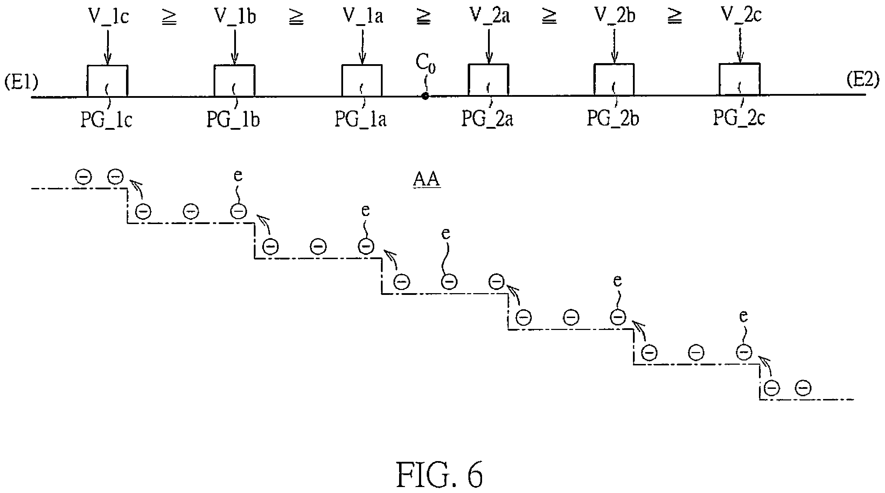

In addition, in addition to being increasing or decreasing outward from the center, the gate voltages V_1a, V_1b, V_1c, V_2a, V_2b and V_2c may be increasing or decreasing from the first end E1 toward the second end E2. In another perspective, the ToF based distance measuring device in the art may receive two clock signals CK1 and CK2 which have 180° phase difference in between. The ToF based distance measuring device receives the clock signal CK1 and operates within a first time period; while the ToF based distance measuring device receives the clock signal CK2 and operates within a second time period. Preferably, during the first time period, the gate voltages V_1a, V_1b, V_1c, V_2a, V_2b and V_2c may be increasing in a direction from the first end E1 toward the second end E2, i.e., V_1c ≤ V_1b ≤ V_1a ≤ V_2a ≤ V_2b ≤ V_2c, where the potential gradient is illustrated in FIG. 5. During the second time period, the gate voltages V_1a, V_1b, V_1c, V_2a, V_2b and V_2c may be decreasing in the direction from the first end E1 toward the second end E2, i.e., V_1c ≥ V_1b ≥ V_1a ≥ V_2a ≥ V_2b ≥ V_2c, where the potential gradient is illustrated in FIG. 6. Therefore, the electrons around the first end E1 may be drifted to the surface of the active region AA within the first time period, and the electrons around the second end E2 may be drifted to the surface of the active region AA within the second time period, such that the draining capability of the photo electron/current is enhanced.

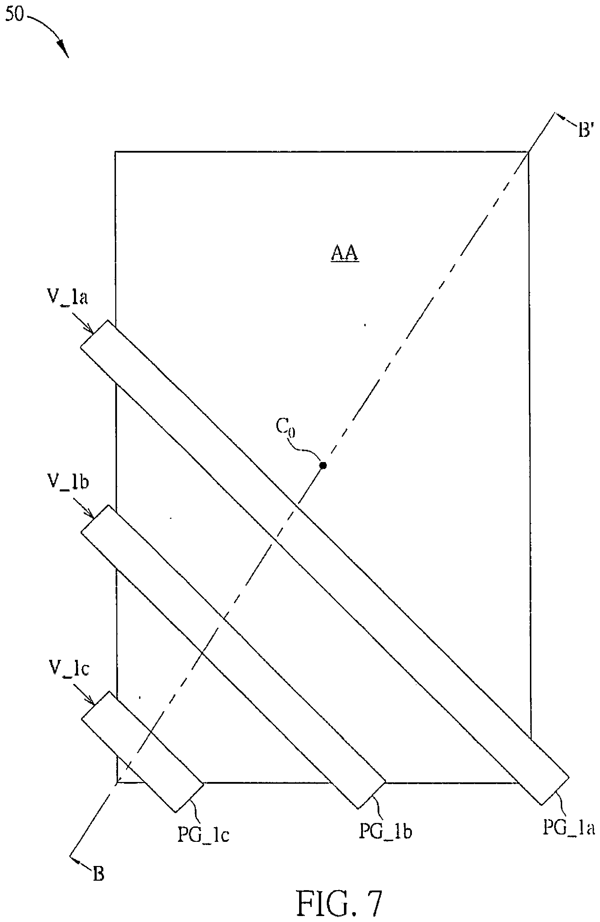

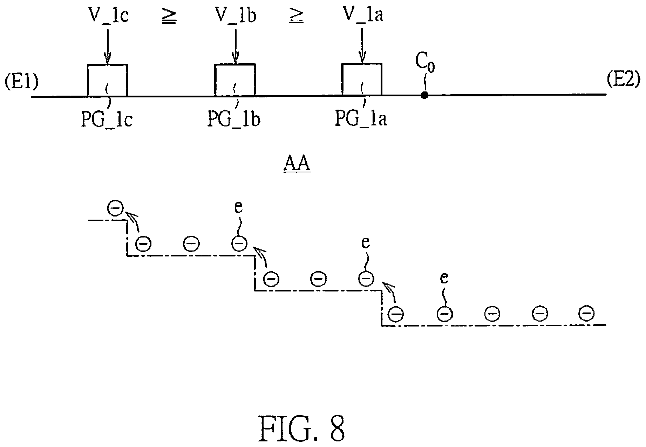

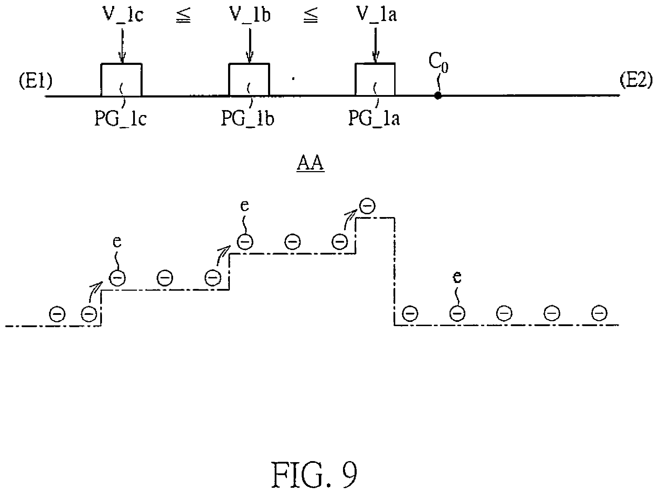

In addition, please refer to FIG. 7. FIG. 7 is a schematic diagram of a top view of a light sensing element 70 according to an embodiment of the present application. The light sensing element 70 is similar to the light sensing element 10, and thus, the same components are denoted by the same notations. Different from the light sensing element 10, the light sensing element 70 comprises the gates PG_1a, PG_1b and PG_1c only (and does not comprise the gates PG_2a, PG_2b and PG_2c) . The gate voltages V_1a, V_1b and V_1c may be increasing from inside to outside (i.e., V_1a ≤ V_1b ≤ V_1c, where the potential gradient is illustrated in FIG. 8) or decreasing from inside to outside (i.e., V_1a ≥ V_1b ≥ V_1c, where the potential gradient is illustrated in FIG. 9), which is also within the scope of the present application.

In summary, the present application utilizes the plurality of gates disposed on the active region and the increasing (or decreasing) gate voltages, to form the potential gradient within the active region, so as to enhance the drifting capability of the photo electrons. For the light with larger wavelength such as IR, the light sensing element of the present application has better draining/reading capability of the photo electron/current.

The foregoing is only embodiments of the present application, which is not intended to limit the present application. Any modification following the spirit and principle of the present application, equivalent substitutions, improvements should be included within the scope of the present invention.

## Claims

1. A light sensing element, configured to receive a light, **characterized in that**, the light sensing element comprises:
an active region; and
a plurality of gates, arranged in an order and disposed on the active region, wherein the plurality of gates receives a plurality of gate voltages, the plurality of gate voltages are corresponding to the plurality of gates arranged in the order, respectively;
wherein the plurality of gate voltages are increasing or decreasing as the order.

2. The light sensing element as claim 1, **characterized in that**, the plurality of gates are arranged from a center of the active region to a periphery of the active region, and the plurality of gate voltages applied to the plurality of gates are increasing from the center to the periphery.

3. The light sensing element as claim 1, **characterized by**, comprising:
a plurality of first gates, arranged from a center of the active region to a first end of the active region, wherein the plurality of first gate voltages applied to the plurality of first gates are increasing from the center to the first end; and
a plurality of second gates, arranged from the center of the active region to a second end of the active region, wherein the plurality of second gate voltages applied to the plurality of second gates are increasing from the center to the second end;
wherein the first end is opposite to the second end.

4. The light sensing element as claim 1, **characterized by**, comprising:
a plurality of first gates, arranged from a center of the active region to a first end of the active region, wherein the plurality of first gate voltages applied to the plurality of first gates are decreasing from the center to the first end; and
a plurality of second gates, arranged from the center of the active region to a second end of the active region, wherein the plurality of second gate voltages applied to the plurality of second gates are decreasing from the center to the second end;
wherein the first end is opposite to the second end.

5. The light sensing element as claim 1, **characterized in that**, the plurality of gates are arranged from a first end of the active region to a second end of the active region, the first end is opposite to the second end, and the plurality of gate voltages are increasing from the first end to the second end.

6. The light sensing element as claim 1, **characterized in that**, the plurality of gates are arranged from a first end of the active region to a second end of the active region, the first end is opposite to the second end, the plurality of gate voltages are increasing from the first end to the second end during a first time period, and the plurality of gate voltages are decreasing from the first end to the second end during a second time period.

7. The light sensing element as claim 1, **characterized in that**, the plurality of gates are mutually parallel.

8. The light sensing element as claim 1, **characterized in that**, the gates are poly-silicon gates.

9. The light sensing element as claim 1, **characterized in that**, a wavelength to the light is greater than 700nm.

10. The light sensing element as claim 1, **characterized in that**, the light sensing element is a photo diode.

11. The light sensing element as claim 1, **characterized in that**, the light sensing element is applied in a Time of Flight (ToF) based distance measuring device.
